# EUROPEAN PATENT SPECIFICATION

(11) **EP 4 513 616 B1**
(45) Date of publication and mention of the grant of the patent: **16.09.2026**
(21) Application number: 24195235.7
(22) Date of filing: 19.08.2024
(51) Int. Cl.: H01M 10/42, G01R 31/52, H01M 10/48, G01R 31/385, G01R 31/392

(54) **APPARATUS FOR CHECKING FOR SHORT CIRCUITS**
VORRICHTUNG ZUR KURZSCHLUSSPRÜFUNG
DISPOSITIF DE CONTRÔLE DE COURT-CIRCUIT

(30) Priority: 21.08.2023 KR 20230109231
(43) Date of publication of application: 26.02.2025
(73) Proprietor: SK On Co., Ltd., Seoul 03161 (KR)
(72) Inventor: RYU, Jae Min, 34124 Daejeon (KR); KIM, Wook Kyoung, 34124 Daejeon (KR); PARK, Sang Jun, 34124 Daejeon (KR); KIM, Kang San, 34124 Daejeon (KR); AHN, Ji Eun, 34124 Daejeon (KR); OH, Young Rae, 34124 Daejeon (KR)
(74) Representative: Stolmár & Partner Patentanwälte PartG mbB

(56) References cited:
- EP-A1- 3 719 915
- CN-U- 211 826 396
- DE-U1- 29 608 009
- KR-A- 20230 046 593

## Description

### CROSS REFERENCE TO RELATED APPLICATION

The present application claims priority to Korean Patent Application No. 10-2023-0109231, filed August 21, 2023.

### BACKGROUND

### 1. Technical Field

Embodiments of the present disclosure relate to an apparatus for checking for a short circuit and, more particularly, to an apparatus for checking for short circuits for use in electrode assemblies.

### 2. Description of the Related Art

A secondary battery is a battery that can be repeatedly charged and discharged, and is applied as a power source having output characteristics and stability in eco-friendly electric vehicles, hybrid electric vehicles, energy storage systems (ESS), and the like.

Usually, the secondary battery may include an electrode assembly that includes a positive electrode plate coated with a positive active material, a negative electrode plate coated with an negative active material, and a separator, as well as a battery case (e.g., a pouch exterior material) for accommodating the electrode assembly and an electrolyte.

Before inserting the electrode assembly into the battery case, the electrode assembly is inspected for a short-circuit occurrence by connecting each probe to a positive electrode tab of the positive electrode plate and to a negative electrode tab of the negative electrode plate respectively, and then by applying a voltage. A short circuit occurs when a positive electrode and a negative electrode adjacent to a damaged area of the separator physically come into contact together and a leakage current is detected by a detector provided that the separator between the positive electrode plate and the negative electrode plate is damaged (e.g., folded, tom, punctured, etc.) when voltage is applied. When the leakage current diverges from the normal range, the electrode assembly is judged to be short-circuited.

In the process of sequentially stacking the positive electrode plate, the separator, and the negative electrode plate, it is difficult for a conventional short measurement device to detect pseudo-defects in the electrode assembly due to the thickness of the separator, the spacing between the separator and the electrode plate, and the mixture of foreign substances. Accordingly, as shown in Patent Reference 1, presented is a method that induces a temporary internal short circuit (short) of the positive electrode plate and the negative electrode plate by applying a surface pressure force to the electrode assembly and then by making the distance between the positive electrode plate and the negative electrode plates as close as possible by means of a pressurization plate. Such a countermeasure may provide the advantage of uniformly pressurizing the entire upper and lower surfaces of the electrode assembly to a predetermined pressure but it may inevitably have limitations in selectively performing partial pressurization on the electrode assembly or measuring electrode assemblies of various sizes.

### Documents of Related Art

(Patent Document 1) Korea Patent Application Publication No. 10-2022-0118250
EP 3 719 915 A1 discloses an apparatus for checking for short circuits including a first pressurization member pressurizing a top surface of the center area of an electrode assembly and a second pressurization member pressurizing opposite edge areas of the electrode assembly, Both the first and second pressurization members are configured to induce downward pressure onto the electrode assembly.

### SUMMARY

Embodiments of the present disclosure provide an apparatus for checking for a short circuit, the apparatus which determines whether an electrode assembly is short-circuited while pressurizing the electrode assembly.

In addition, an embodiment of present disclosure is configured to continuously determine whether the electrode assembly is short-circuited.

The apparatus for checking for short circuits according to an embodiment of the present disclosure includes a support plate that supports the bottom surface of a center area of an electrode assembly, a pressurization unit that includes a first pressurization member pressurizing a top surface of the center area of the electrode assembly and a second pressurization member pressurizing opposite edge areas of the electrode assembly and a short circuit measurement unit applying voltage to the electrode assembly to check for a short circuit, wherein the pressurization unit is configured to partially pressurize the entire upper and lower surfaces of the electrode assembly per an area.

In an embodiment of the present disclosure, the pressurization unit may be separated into first and second pressurization members and may be arranged spaced apart from each other.

In an embodiment of the present disclosure, the support plate may include an ejection pin arranged to move up and down.

The second pressurization member includes an upper pressurization block and a lower pressurization block arranged for reciprocating up and down with opposite edge areas of the electrode assembly placed therebetween.

In an embodiment of the present disclosure, the second pressurization member may be positioned at the same vertical line as the edge of the positive electrode plate to pressurize opposite edges of the positive electrode plate of the electrode assembly.

The apparatus for checking for short circuits according to an embodiment not according to the claimed invention includes a transfer unit configured to move a support plate on which the electrode assembly is mounted along a guide rail, a pressurization unit configured to pressurize the entire upper and lower surfaces of the electrode assembly, a short circuit measurement unit configured to determine whether there is a short circuit by applying voltage to the electrode assembly, and a mounting unit configured to position and arrange the pressurization unit along the length direction of the electrode assembly on the transfer unit.

An embodiment not according to the claimed invention may separate the electrode assembly into a center area and opposite edge areas that are symmetrically arranged along the length direction of the electrode assembly while being centered around the center area.

In another embodiment not according to the claimed invention, the support plate may be formed in the size and shape capable of supporting the center area of the electrode assembly.

In another embodiment not according to the claimed invention, the support plate may include an ejection pin on the top surface facing the center area of the electrode assembly.

In another embodiment not according to the claimed invention, the pressurization unit may include the first pressurization member for pressurizing the top surface of the center area of the electrode assembly and the second pressurization member for pressurizing opposite edge areas of the electrode assembly.

In another embodiment of the present disclosure, the pressurization unit may be separated into first and second pressurization members and may be arranged spaced apart from each other.

In another embodiment not according to the claimed invention, the second pressurization member may include an upper pressurization block and a lower pressurization block arranged for reciprocating up and down with opposite edge areas of the electrode assembly placed therebetween.

In another embodiment not according to the claimed invention, the mounting unit includes a horizontal frame extending orthogonally over the transfer unit, a vertical frame that is installed to be slidable in the length direction of the horizontal frame and is arranged to be coupled with the second pressurization member of the pressurization unit for moving up and down and a driving means that is arranged to be coupled with the horizontal frame in order to enable the first pressurization member of the pressurization unit to move up and down.

In another embodiment not according to the claimed invention, the short circuit measurement unit may be arranged in the second pressurization member to enable to move up and down a first probe and a second probe which contact with the positive electrode tab and the negative electrode tab of the electrode assembly and apply voltage.

In another embodiment not according to the claimed invention, the transfer unit may additionally include a clamping plate for clamping or unclamping the electrode assembly on the support plate.

The features and advantages of the embodiments of the present disclosure will become more apparent from the following detailed description based on the accompanying drawings.

It should be noted that the terms and words used in this specification and claims are not to be construed in their ordinary and dictionary sense, but are to be construed with a meaning and concept consistent with the technical idea of the present disclosure, based on the principle that inventors may define the concept of a term as they see fit to best describe their disclosure.

According to the above description of the embodiments of the present disclosure, the embodiments can reliably check for a short circuit on the electrode assembly while pressurizing the entire upper and lower surfaces of the electrode assembly.

In particular, an embodiment may partially pressurize the entire upper and lower surfaces of the electrode assembly per an area in order to more accurately identify the damaged part of the separator. Further, the embodiments may be universally applied to electrode assemblies of various standards through the above-described partial pressurization on the electrode assembly.

In addition, the embodiments of the present disclosure may provide the advantage of not only enabling total inspection but also shortening the measurement time by continuously performing short circuit measurements of the electrode assembly.

The embodiments of the present disclosure may reduce unnecessary additional labor and material losses by detecting abnormalities (e.g., short circuits) in advance in the electrode assembly before the process of packaging the electrode assembly in a battery case or activating it after packaging. These and other features and advantages of the invention will become apparent from the detailed description of embodiments of the present disclosure and the following figures.

### BRIEF DESCRIPTION OF THE DRAWINGS

FIG. 1 is a simplified cross-sectional view schematic illustrating an electrode assembly.
FIG. 2 is a simplified side cross-sectional view schematic illustrating a configuration of an apparatus for checking for short circuits according to an embodiment of the present disclosure.
FIG. 3 is another simplified cross-sectional view schematic illustrating an operation of detecting short circuits of an electrode assembly of the apparatus for checking for short circuits of FIG. 2.
FIG. 4 is a simplified top perspective view schematic of a support plate applied to an apparatus for checking for short circuits according to an embodiment of the present disclosure.
FIG. 5 is a view schematically illustrating a configuration of an apparatus for checking for short circuits according to an embodiment not according to the claimed invention.
FIG. 6 is a simplified view schematic illustrating the process of detecting short circuits of an electrode assembly using an apparatus for checking for short circuits according tc an embodiment not according to the claimed invention.

### DETAILED DESCRIPTION

The obj ectives, advantages, and features of the present disclosure will become more apparent from the following detailed description and various embodiments taken in conjunction with the accompanying drawings, but the present disclosure is not necessarily limited thereto.

The embodiments described in this disclosure and the accompanying drawings are not intended to limit the disclosure to specific embodiments.

In assigning reference numerals to components in the drawings, it should be noted that identical components are assigned the same reference numerals as much as possible even when they are shown in different drawings, and similar components are assigned similar reference numerals.

In this disclosure, terms such as first and second are used to distinguish one component from another component, and the components are not limited by the terms. In the accompanying drawings, some components are exaggerated, omitted, or schematically shown, and the size of each component does not entirely reflect the actual size.

Hereinafter, with reference to the accompanying drawings, an apparatus for checking for short circuits according to embodiments of the present disclosure will be described in detail.

The embodiments relate to an apparatus for checking for short circuits capable of detecting whether a short circuit occurs in an electrode assembly using a pressurization method. The apparatus may be preferably configured to check for a short circuit while pressurizing the entire upper and lower surfaces of the electrode assembly.

Further, embodiments not according to the claimed invention may detect whether an electrode assembly is short-circuited while guiding the electrode assembly to a subsequent process (e.g., an assembly process in which the electrode assembly is inserted into a battery case together with an electrolyte) after mounting the electrode assembly that includes a positive electrode plate, a negative electrode plate and a separator on the transfer unit.

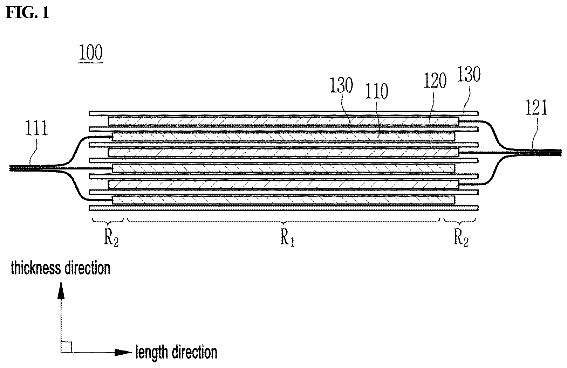

As widely known to those skilled in the art, the electrode assembly 100 includes a plurality of positive electrode plates 110, a plurality of negative electrode plates 120, and a separator 130 inserted and placed for providing insulation between the positive electrode plates 110 and the negative electrode plates 120, as shown in FIG. 1. The electrode assembly 100 may be configured to place the separator 130 on the outermost layer, that is, the uppermost layer and the lowermost layer.

For reference, a positive electrode tab 111 may extend outward from the outer edge of the positive electrode plate 110, and a negative electrode tab 121 may extend outward from the outer edge of the negative electrode plate 120. As shown, the electrode assembly 100 may have the positive electrode tab 111 and the negative electrode tab 121 extending in opposite directions from each other from opposite edges of the length direction of the electrode assembly. Here, the length direction of the electrode assembly may mean the withdrawal direction of the electrode tabs 111, 121.

Referring to FIG. 1, it may be determined whether the electrode assembly is short-circuited by contacting a first probe and a second probe of the apparatus to check for short circuits, which will be described later, in a state where a plurality of positive electrode tabs and a plurality of negative electrode tabs protruding from the electrode assembly 100 are brought together and are overlapped with the same electrode. A plurality of positive electrode tabs and a plurality of negative electrode tabs bond in each bundle form through pre-welding to prevent separation in a state where the positive electrode tabs 111 and the negative electrode tabs 121 may be respectively gathered according to the same electrode, and a bundle of positive electrode tabs and a bundle of negative electrode tabs may contact the first probe and the second probe respectively. A check for short circuits may also be provided by welding a plurality of positive electrode tabs 111 to one electrode lead (not shown) and a plurality of negative electrode tabs 121 to the other electrode lead (not shown) via lead welding, and then by contacting the one electrode lead and the other electrode lead of the electrode assembly with the first and second probes respectively.

For example, the separator 130 has a relatively larger size (e.g., area) than the positive electrode plate 110 and the negative electrode plate 120 to prevent the short circuit of the positive electrode plate 110 and the negative electrode plate 120.

It is known that the charge and discharge efficiency decreases due to the growth of lithium dendrites in secondary batteries, such as lithium secondary batteries. A desired level of battery performance effectiveness can be secured by using a large area of the negative electrode plate 120 to suppress the formation of such lithium dendrites. That is, the negative electrode plate 120 may be structured such that the area of the negative electrode plate 120 is relatively larger than the area of the positive electrode plate 110.

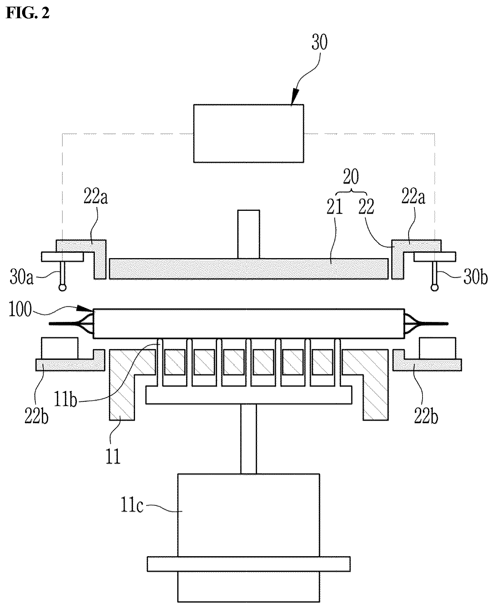

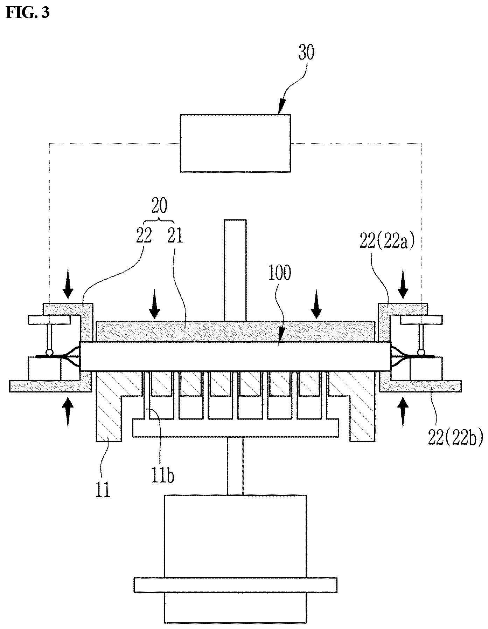

Referring to FIGS. 2 to 4, the apparatus for checking for short circuits according to an embodiment of the present disclosure electrically connects a short circuit measurement unit 30 with the previously described electrode assembly 100.

The short circuit measurement unit 30 includes a power source (not shown) that applies voltage to the electrode assembly and a current measurement unit (not shown) that checks for leakage current, and is provided with the first probe 30a and the second probe 30b for applying a predetermined voltage from the power source to the electrode assembly 100. As shown, the short circuit measurement unit 30 is connected to the electrode assembly 100 by contacting the first probe 30a with the positive electrode tab 111 and by contacting the second probe 30b with the negative electrode tab 121. Thereby, the short circuit measurement unit 30 may detect the short circuit of the electrode assembly 100 by applying a predetermined voltage to the positive electrode tab 111 and the negative electrode tab 121 of the electrode assembly 100.

When a predetermined voltage is applied to the electrode assembly 100, an internal short circuit occurs and leakage current is detected in the damaged part of the separator 130 interposed between the positive electrode plate 110 and the negative electrode plate 120. Thus, the apparatus for checking for short circuits of the present disclosure may identify failures caused by defects of the separator when the measured leakage current exceeds the normal range.

The apparatus for checking for short circuits of the present disclosure may detect true defects (actual defects) in the short circuit measurement unit through leakage current as described above. In addition, the apparatus is configured to detect pseudo defects such as a gap between the separator 130 and the positive electrode plate (or the negative electrode plate), the pseudo defects which are not actual product defects.

To improve the detection power of not only true defects but also pseudo defects, an embodiment of the present disclosure has the feature of applying voltage while keeping the distance between the positive electrode plate, the separator, and the negative electrode plate as close as possible by applying surface pressure to the electrode assembly. That is, voltage is applied while pressurizing the electrode assembly which detects whether the electrode assembly has a short circuit by intentionally inducing a short circuit after physically contacting, the positive electrode plate and the negative electrode plate placed adj acent to the damaged part of the separator, to each other when the separator has a damaged part.

Preferably, the apparatus for checking for short circuits according to an embodiment of the present disclosure may check for a short circuit while pressurizing a top surface and a bottom surface in the thickness direction of an electrode assembly.

More preferably, the apparatus for checking for short circuits according to an embodiment of the present disclosure may partially pressurize the entire top surface and bottom surface of the electrode assembly of the electrode assembly for each area.

For this, the apparatus for checking for short circuits according to an embodiment of the present disclosure may include a support plate 11 that supports the electrode assembly 100, a pressurization unit 20 that pressurizes the entire upper and lower surfaces of the electrode assembly 100, and a short circuit measurement unit 30 that detects an internal short circuit by applying voltage to the electrode assembly 100.

An embodiment of the present disclosure includes a support plate 11 for supporting the electrode assembly 100. The support plate 11 faces and supports one of the flat surfaces of the electrode assembly, for example, the undersurface of the electrode assembly 100.

As shown, the support plate 11 may be formed in a size and shape capable of supporting the center area R1 of the electrode assembly 100. That is, the support plate 11 is arranged to support not opposite edge areas R2 of the electrode assembly 100 but the center area R1. Here, the electrode assembly 100 is arranged to symmetrically extend opposite edge areas R2 along the length direction centering on the center area R1 of the electrode assembly 100. As shown in FIG. 1, opposite edge areas R2 refer to the areas adj acent to opposite edges of the positive electrode plate 110 facing the separator 130 and/or the negative electrode plate 120.

Accordingly, the support plate 11 may support the electrode assembly at a position that does not interfere with opposite edge areas R2 of the electrode assembly 100.

An embodiment includes a pressurization unit 20 that is configured to partially pressurize the entire upper and lower surfaces of the electrode assembly 100 by dividing them into areas. As shown, the entire upper and lower surfaces of the electrode assembly may be formed in a flat shape.

The pressurization unit 20 may be composed of the first pressurization member 21 and the second pressurization member 22 which may be separated into the first pressurization member 21 and the second pressurization member 22 that are spaced apart from each other. Optionally, an embodiment may configure the pressurization unit 20 to include a second pressurization member 22, a first pressurization member 21, the second pressurization member 22 sequentially arranged along the length direction of the electrode assembly 100.

The first pressurization member 21 may pressurize a part corresponding to the center area (R1; see FIG. 1) of the electrode assembly 100, and may be specifically positioned for reciprocating up and down over the support plate 11.

The second pressurization member 22 may pressurize a part corresponding to opposite edge areas (R2; see FIG. 1) of the electrode assembly 100 independently of the first pressurization member 21. Preferably the second pressurization member 22 may be provided at respectively opposite edges of the length direction of the electrode assembly 100.

Since damage to the separator generally occurs at the corners of the electrode assembly, the embodiment may effectively pressurize opposite edge areas of the electrode assembly where the possibility of damage to the separator is high, by means of the second pressurization member 22.

Furthermore, an advantage of reliably fixing the corners of the electrode assembly using the second pressurization member 22 to keep the alignment of the electrode assembly constant while checking for a short circuit is achieved. Specifically, the second pressurization member 22 is enabled to pressurize opposite edges of the positive electrode plate 110 which has a smaller area than the negative electrode plate 120 and the separator 130.

The second pressurization member 22 includes a pair of pressurization blocks arranged opposite each other with opposite edge areas of the electrode assembly in between, and is configured to include an upper pressurization block 22a reciprocating up and down above the top surface of opposite edge areas of the electrode assembly 100 and a lower pressurization block 22b reciprocating up and down below the bottom surface of opposite edge areas of the electrode assembly 100. The upper pressurization block 22a is configured to move upward to pressurize or downward to unpressurize opposite edge areas R2 of the electrode assembly 100 mounted on the support plate 11, and correspondingly the lower pressurization block 22b is configured to move upward to pressurize or downward to unpressurize opposite edge areas R2 of the electrode assembly 100 mounted on the support plate 11.

Furthermore, the second pressurization member 22 arranges the upper pressurization block 22a and the lower pressurization block 22b on the same vertical line in the thickness direction of the electrode assembly. Specifically, the second pressurization member 22 may be placed on the same vertical line as the edge of the positive electrode plate.

The first pressurization member, the upper pressurization block, and the lower pressurization block reciprocate up and down using a driving means (not shown). For reference, the driving means may be a hydraulic cylinder, a pneumatic cylinder, or a drive motor, and any configuration may be used when reciprocating up and down in the thickness direction orthogonal to the length direction of the electrode assembly.

Optionally, the first pressurization member 21 and the second pressurization member 22 may be provided with a buffer pad (not shown) on the pressurization part that interfaces with the electrode assembly. For example, the second pressurization member 22 may be provided with a buffer pad on the bottom surface of the upper pressurization block 22a and the top surface of the lower pressurization block 22b.

The buffer pad may prevent damage to the separator 130 in advance while pressurizing the electrode assembly 100 through the first pressurization member and second pressurization member.

An embodiment of the present disclosure may install a first probe 30a and a second probe 30b on an upper pressurization block 22a of the second pressurization member 22 to easily apply voltage while pressurizing opposite edge areas R2 of the electrode assembly 100 placed adjacent to the positive electrode tab 111 and/or the negative electrode tab 121 using the second pressurization member 22. The first probe 30a and the second probe 30b may be spaced apart from each other from the upper pressurization block 22a toward the outer front as shown.

Additionally or alternatively, the ejection pins 11b may be arranged to be capable of moving up and down on the support plate 11 so that the electrode assembly 100 may be easily separated from the support plate 11 after checking for short circuits. The support plate 11 includes a plurality of pinholes 11a perforated in the thickness direction on a top surface thereof, a plurality of ejection pins 11b respectively inserted through the plurality of pinholes 11a to move up and down, and a hoisting means 11c for hoisting the plurality of the ejection pins 11b.

To synchronize the ascending and descending movement of the plurality of ejection pins 11b, the plurality of ejection pins may be installed and fixed to the ejection plate (no reference numeral). The ejection plate is coupled to the hoisting means 11c and may move the plurality of ejection pins up and down according to driving of the hoisting means.

When the electrode assembly is released from the pressurization, the front end of the ejection pin protrudes from the upper surface of the support plate 11 so that the electrode assembly 100 may be separated from the support plate 11 whereas the ejection pins 11b may move backward into the pinholes 11a while checking for short circuits by pressurizing the electrode assembly using the pressurization unit. As a result, the electrode assembly may be supported with the ejection pins through the ascending movement of the ejection pins 11b, thereby allowing the electrode assembly to be quickly and reliably taken out into a subsequent process.

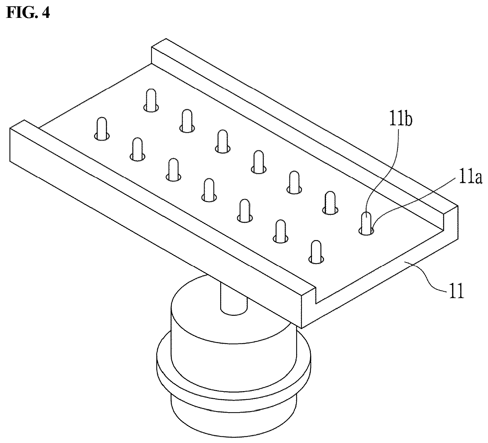

As shown in FIG. 4, a plurality of ejection pins 11b are spaced apart from each other in the inner area of the support plate 11, and thereby may support the electrode assembly evenly and horizontally. For example, a plurality of ejection pins 11b may be arranged in a grid-like pattern at uniform intervals on the top surface of the support plate 11.

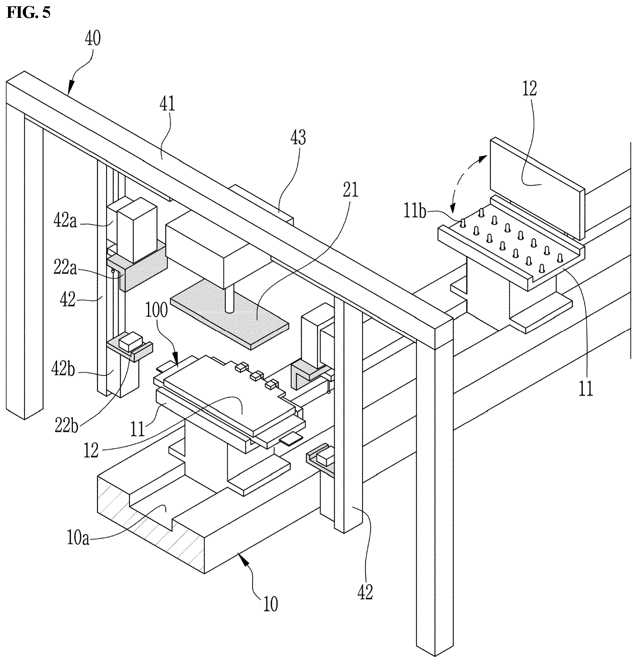

The apparatus for checking for short circuits according to an embodiment not according to the claimed invention is configured to continuously check for a short circuit of an electrode assembly and is configured to detect whether a short circuit occurs while sequentially transferring an electrode assembly to be measured as shown in FIGS. 5 to 6.

As shown, the apparatus for checking for short circuits according to an embodiment not according to the claimed invention includes a transfer unit 10 that sequentially transfers the electrode assembly 100 in a certain direction according to the process sequence, a pressurization unit 20 that pressurizes the entire upper and lower surfaces of the electrode assembly mounted on the transfer unit 10, a short circuit measurement unit 30 that detects an internal short circuit by applying voltage to the electrode assembly (see FIG. 2), and a mounting unit 40 that helps to select the position of the pressurization unit 20 to pressurize the entire upper and lower surfaces of the electrode assembly.

As described above, an embodiment not according to the claimed invention may be configured to enable the electrode assembly 100 to be mounted on the transfer unit 10 and to sequentially enter the pressurization unit 20.

Here, the transfer unit 10 may be a component member capable of linearly moving an object to be measured in the horizontal direction, and may include a guide rail (no reference sign) extending along the driving direction of the electrode assembly 100 and a support plate 11 driving along the guide rail. An embodiment not according to the claimed invention may position the electrode assembly 100 on the support plate 11 that may slide along the guide rail of the transfer unit 10, and then guide the electrode assembly 100 to be positioned at the pressurization unit 20.

Optionally, the transfer unit 10 may include a clamping plate 12 that clamps or unclamps the electrode assembly on the support plate 11.

The apparatus for checking for short circuits according to an embodiment not according to the claimed invention may position the electrode assembly in the pressurization unit 20 as shown in FIG. 5 by means of a transfer unit 10 moving with the mounted electrode assembly 100. Then, the apparatus may check for internal short circuits of the electrode assembly using the short circuit measurement unit 30 (see FIG. 2) and then guide to the next facility. Optionally the support plate 11 may be able to move at a constant speed in the extending direction of the guide rail.

As shown, the support plate 11 is formed in a size and shape capable of supporting the bottom surface of the center area R1 of the electrode assembly 100 and provides a space for installing the clamping plate 12. Corresponding to the support plate, the clamping plate 12 may be formed in a size and shape capable of covering the top surface of the center area of the electrode assembly 100.

Moreover, the support plate 11 is provided with a plurality of ejection pins 11b on the top surface facing the electrode assembly 100, more specifically, facing the center area R1 of the electrode assembly. The ejection pin 11b is provided to move up and down to separate the electrode assembly 100 from the support plate 11, which is described in detail with reference to FIG. 4.

As shown, in an embodiment not according to the claimed invention the first pressurization member 21 and the second pressurization member 22 may be positioned along the length direction of the electrode assembly by means of the mounting unit 40.

Specifically, the mounting unit 40 includes a horizontal frame 41 positioned over the transfer unit 10 that is configured to move with the mounted electrode assembly 100, a vertical frame 42 installed to slide in the length direction of the horizontal frame 41, and a drive means 43 coupled to the horizontal frame 41 to enable the first pressurization member 21 to reciprocate up and down. The horizontal frame 41 is arranged in a direction orthogonal to the driving direction of the electrode assembly, and may be arranged orthogonal to the transfer unit.

Additionally, an embodiment not according to the claimed invention may be configured to arrange the first pressurization member 21 to be on the same vertical line as the support plate 11 of the transfer unit 10.

The first pressurization member 21 is capable of pressurizing or depressurizing the electrode assembly downward and, more specifically, the center area R1 of the electrode assembly 100 using the drive means 43.

Upon pressurization of the first pressurization member, a surface pressure on the center area of the electrode assembly 100 is provided by pressurizing the clamping plate 12 covering the top surface of the center area of the electrode assembly using the first pressurization member 21. For this, the clamping plate 12 should be configured to clamp or unclamp the electrode assembly and at the same time be configured to move up and down by the pressurization of the first pressurization member in a state of covering the top surface of the center area of the electrode assembly.

Preferably, an embodiment not according to the claimed invention includes a first slider 42a and a second slider 42b that are coupled to move up and down along the length direction of the vertical frame 42. The second pressurization member 22 includes the upper pressurization block 22a and the lower pressurization block 22b arranged opposite to each other and the upper pressurization block 22a is coupled to the first slider 42a whereas the lower pressurization block 22b is coupled to the second slider 42b. The upper pressurization block 22a may move down or up to pressurize downward or depressurize the top surfaces of opposite edges of the electrode assembly 100 in dependence on (or urged by) the downward or upward movement of the first slider 42a. Corresponding to this, the lower pressurization block 22b can pressurize upward or depressurize the bottom surfaces of opposite edges of the electrode assembly 100 in dependence on the upward and downward movement of the second slider 42b.

As described before the first and second probes 30a, 30b may be positioned on the outer front side of the upper pressurization block 22a to apply voltage while pressurizing the electrode assembly. Accordingly, the first and second probes 30a, 30b may be arranged to move up and down in conjunction with the upward and downward movement of the upper pressurization block 22a.

As shown in FIG. 5, an embodiment not according to the claimed invention may allow the electrode assembly 100, (which is to be measured) to enter or exit between the upper and lower pressurization blocks 22a and 22b which are spaced apart from each other on the vertical frame 42.

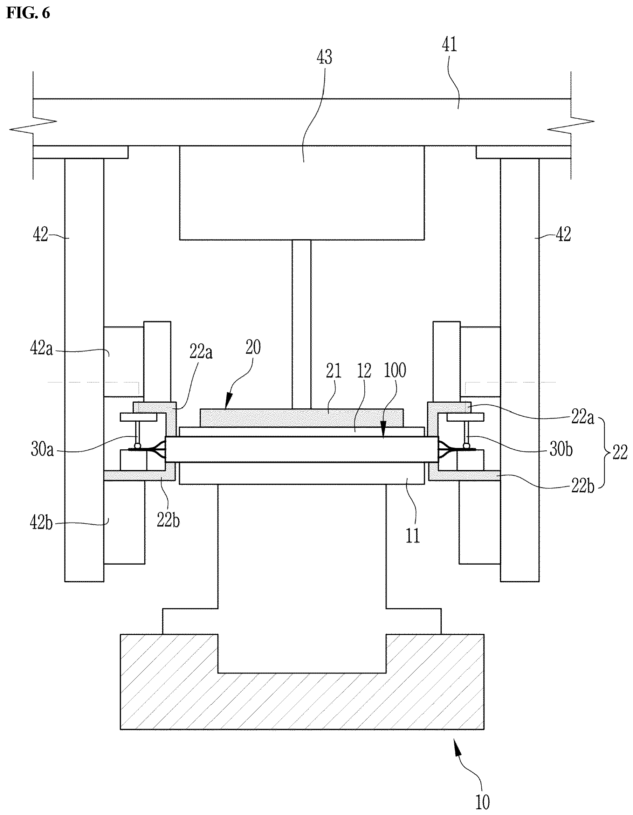

As shown in FIG. 6, an embodiment not according to the claimed invention may reliably pressurize opposite edge areas R2 of the electrode assembly 100 by adjusting the distance between the upper pressurization block 22a and the lower pressurization block 22b on the vertical frame 42 in the direction of contact with each other. Through the descending movement of the upper pressurization block 22a, the first probe 30a and the second probe 30b may contact the positive electrode tab and the negative electrode tab of the electrode assembly 100 and then apply a predetermined voltage. Through this, the short circuit measurement unit 30 may be electrically connected to the electrode assembly 100 and then determine whether the electrode assembly is defective (for example, short circuits).

As shown, the vertical frame 42 along with the second pressurization member 22 may be arranged in a mirror symmetrical way centering on the drive means 43 in the horizontal frame 41. As a result, this helps to pressurize opposite edge areas R2 of the electrode assembly 100 using the second pressurization member 22.

As described above, the horizontal position of the second pressurization member 22 may change in the length direction of the electrode assembly 100 mounted on the support plate 11 because the vertical frame 42 having the second pressurization member 22 is installed to be slidable on the horizontal frame 41. By doing so, the opposite edge areas R2 of the electrode assembly are aligned between the upper pressurization block 22a and the lower pressurization block 22b of the second pressurization member 22 by changing the horizontal position of the second pressurization member 22 according to the size of the electrode assembly.

Various embodiments of the present disclosure have been described in detail. The embodiments are provided as implementation examples of the present invention, and are not intended to limit the scope of the present invention to these examples only. It will be clear that modifications and improvements can be made by those skilled in the art within the scope and according to the technical concepts of the present disclosure.

It should be understood that many modifications, changes and other embodiments may fall within the scope of the present invention as defined by the appended claims. Furthermore, the embodiments may be combined to from additional embodiments.

## Claims

1. An apparatus for checking for short circuits, the apparatus comprising:
a support plate (11) that supports a bottom surface of a center area of an electrode assembly (100);
a pressurization unit (20) that includes a first pressurization member (21) pressurizing a top surface of the center area of the electrode assembly (100) and a second pressurization member (22) pressurizing opposite edge areas of the electrode assembly (100); and
a short circuit measurement unit (30) applying a voltage to the electrode assembly (100) to check for a short circuit of the assembly,
wherein the second pressurization member (22) comprises an upper pressurization block (22a) and a lower pressurization block (22b) arranged for reciprocating up and down at a location between opposite edge areas of the electrode assembly (100), and
wherein the pressurization unit (20) partially pressurizes entire upper and lower surfaces of the electrode assembly (100) for each area.

2. The apparatus for checking for short circuits of claim 1, wherein the pressurization unit (20) is separated into first and second pressurization members (21, 22) that are spaced and arranged apart from each other.

3. The apparatus for checking for short circuits of any one of claim 1 or 2, wherein the support plate (11) comprises an ejection pin (11b) arranged to move up and down.

4. The apparatus for checking for short circuits of any one of claims 1 to 3, wherein the second pressurization member (22) is positioned at the same vertical line as an edge of a positive electrode plate (110) of the electrode assembly (100) in order to pressurize opposite edges of the positive electrode plate (110).

## Patentansprüche

1. Vorrichtung zum Prüfen auf Kurzschlüsse, wobei die Vorrichtung Folgendes umfasst:
eine Trägerplatte (11), die eine Bodenfläche eines Mittelbereichs einer Elektrodenanordnung (100) trägt;
eine Druckbeaufschlagungseinheit (20), die ein erstes Druckbeaufschlagungselement (21), das eine obere Fläche des Mittelbereichs der Elektrodenanordnung (100) mit Druck beaufschlagt, und ein zweites Druckbeaufschlagungselement (22), das gegenüberliegende Randbereiche der Elektrodenanordnung (100) mit Druck beaufschlagt, enthält; und
eine Kurzschlussmesseinheit (30), die eine Spannung an die Elektrodenanordnung (100) anlegt, um auf einen Kurzschluss der Anordnung zu prüfen,
wobei das zweite Druckbeaufschlagungselement (22) einen oberen Druckbeaufschlagungsblock (22a) und einen unteren Druckbeaufschlagungsblock (22b) umfasst, die so angeordnet sind, dass sie sich an einer Stelle zwischen gegenüberliegenden Randbereichen der Elektrodenanordnung (100) auf und ab hin- und herbewegen, und
wobei die Druckbeaufschlagungseinheit (20) die gesamte obere und untere Fläche der Elektrodenanordnung (100) für jeden Bereich teilweise mit Druck beaufschlagt.

2. Vorrichtung zum Prüfen auf Kurzschlüsse nach Anspruch 1, wobei die Druckbeaufschlagungseinheit (20) in ein erstes und ein zweites Druckbeaufschlagungselement (21, 22) unterteilt ist, die voneinander beabstandet und voneinander beabstandet angeordnet sind.

3. Vorrichtung zum Prüfen auf Kurzschlüsse nach einem der Ansprüche 1 oder 2, wobei die Trägerplatte (11) einen Auswurfstift (11b) umfasst, der so angeordnet ist, dass er sich auf und ab bewegt.

4. Vorrichtung zum Prüfen auf Kurzschlüsse nach einem der Ansprüche 1 bis 3, wobei das zweite Druckbeaufschlagungselement (22) an derselben vertikalen Linie wie ein Rand einer positiven Elektrodenplatte (110) der Elektrodenanordnung (100) positioniert ist, um gegenüberliegende Ränder der positiven Elektrodenplatte (110) mit Druck zu beaufschlagen.

## Revendications

1. Dispositif de contrôle des courts-circuits, ledit dispositif comprenant :
une plaque de support (11) qui supporte une surface inférieure d'une zone centrale d'un ensemble d'électrodes (100) ;
une unité d'application de pression (20) comprenant un premier élément d'application de pression (21) qui applique une pression sur une surface supérieure de la zone centrale de l'ensemble d'électrodes (100), et un deuxième élément d'application de pression (22) qui applique une pression sur des zones de bord opposées de l'ensemble d'électrodes (100) ; et
une unité de mesure de court-circuit (30) qui applique une tension à l'ensemble d'électrodes (100) afin de vérifier s'il y a court-circuit dans l'ensemble,
le deuxième élément d'application de pression (22) comprenant un bloc d'application de pression supérieur (22a) et un bloc d'application de pression inférieur (22b), qui sont agencés de manière à effectuer un mouvement de va-et-vient vertical en un emplacement situé entre des zones de bord opposées de l'ensemble d'électrodes (100), et
l'unité de mise sous pression (20) exerçant une pression partielle sur l'ensemble des surfaces supérieure et inférieure de l'ensemble d'électrodes (100) pour chaque zone.

2. Dispositif de contrôle des courts-circuits selon la revendication 1, dans lequel l'unité de mise sous pression (20) est divisée en un premier et un deuxième éléments de mise sous pression (21, 22) qui sont espacés l'un de l'autre.

3. Dispositif de contrôle des courts-circuits selon l'une des revendications 1 ou 2, dans lequel la plaque de support (11) comprend une tige d'éjection (11b) agencée de manière à se déplacer vers le haut et vers le bas.

4. Dispositif de contrôle des courts-circuits selon l'une des revendications 1 à 3, dans lequel le deuxième élément d'application de pression (22) est positionné sur la même ligne verticale qu'un bord d'une plaque d'électrode positive (110) de l'ensemble d'électrodes (100), afin d'exercer une pression sur les bords opposés de la plaque d'électrode positive (110).
